(19) Europäisches Patentamt / European Patent Office / Office européen des brevets

(11) **EP 4 611 050 A1**

(12) **EUROPEAN PATENT APPLICATION**
published in accordance with Art. 153(4) EPC

(43) Date of publication:
**03.09.2025 Bulletin 2025/36**

(21) Application number: 23882734.9

(22) Date of filing: **26.10.2023**

(51) International Patent Classification (IPC):
**H01L 33/20** (2010.01)   **H01L 33/10** (2010.01)
**H01L 33/32** (2010.01)

(52) Cooperative Patent Classification (CPC):
**H10H 20/814; H10H 20/819; H10H 20/82;
H10H 20/825; H10H 20/832**

(86) International application number:
**PCT/JP2023/038772**

(87) International publication number:
**WO 2024/090532 (02.05.2024 Gazette 2024/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 28.10.2022  JP 2022173806
25.10.2023  JP 2023183569

(71) Applicant: DOWA Electronics Materials Co., Ltd.
Tokyo 101-0021 (JP)

(72) Inventor: WATANABE, Yasuhiro
Tokyo 101-0021 (JP)

(74) Representative: Müller-Boré & Partner
Patentanwälte PartG mbB
Friedenheimer Brücke 21
80639 München (DE)

(54) **ULTRAVIOLET LIGHT EMITTING ELEMENT AND METHOD OF PRODUCING SAME**

(57) **Provided** are an ultraviolet light-emitting element with which high light emission output is obtained and a method of producing the same. The ultraviolet light-emitting element includes a transparent substrate having a main surface that constitutes a light extraction surface, an AlN layer on the transparent substrate, an n-type semiconductor layer on the AlN layer, a quantum well-type light-emitting layer on the n-type semiconductor layer, a p-side semiconductor layer directly on the quantum well-type light-emitting layer, and a reflective electrode directly on the p-side semiconductor layer. A side surface of the transparent substrate is a rough surface. Thickness L (nm) of the p-side semiconductor layer satisfies $2L/\cos\theta = \lambda(2k + 1)/2n$ with respect to a central emission wavelength $\lambda$ (nm) of the quantum well-type light emitting layer, a refractive index $n$ of the p-side semiconductor layer, a natural number $k$, and an emission angle $\theta$ of light traveling toward inside of the p-side semiconductor layer from the quantum well-type light-emitting layer, and is within a range where the emission angle $\theta$ is an angle at which light extraction from the transparent substrate into air would not occur in a case in which the main surface and the side surface of the transparent substrate are flat surfaces.

FIG. 1

**Description**

TECHNICAL FIELD

The present disclosure relates to an ultraviolet light-emitting element and a method of producing the same.

BACKGROUND

Light-emitting elements having aluminum gallium nitride (AlGaN) as a main constituent are capable of emitting light of approximately 250 nm to 360 nm, which corresponds to ultraviolet light. Since ultraviolet light-emitting elements having a central emission wavelength corresponding to UVC ($\leq$ 280 nm) or UVB (280 nm to 320 nm) are used in sterilization, for example, there has been particularly active development of ultraviolet light-emitting elements for these wavelength regions. UVA ($\geq$ 320 nm) ultraviolet light-emitting elements are used for resin curing, medical applications, and analytical applications.

Patent Literature (PTL) 1 discloses an ultraviolet light-emitting element that emits deep ultraviolet light of 240 nm to 320 nm. It is disclosed that in this ultraviolet light-emitting element, it is preferable for an electron blocking layer to have a thickness of 1 nm to 10 nm, a p-type cladding layer to have a thickness of 10 nm to 100 nm, and a p-type contact layer to have a thickness of more than 500 nm. It is also disclosed that increasing the thickness of the p-type contact layer makes it possible to improve flatness of the p-type contact layer.

PTL 2 discloses a nitride semiconductor ultraviolet light-emitting element. It is disclosed that in this ultraviolet light-emitting element, output is improved through roughening of the surface of an active layer to a degree that the average roughness thereof is equal to or greater than the thickness of a well layer. Moreover, with regard to the thicknesses of semiconductor layers, an electron blocking layer thickness of 15 nm to 30 nm, a p-type cladding layer thickness of 500 nm to 600 nm, and a p-type contact layer thickness of 100 nm to 300 nm are given as examples.

PTL 3 discloses the provision of an ultraviolet light-emitting element that enables a narrower light distribution angle.

CITATION LIST

Patent Literature

PTL 1: JP6814902B1

PTL 2: WO2017/013729A1

PTL 3: JP2015-119108A

SUMMARY

(Technical Problem)

It has conventionally been considered preferable for a light-emitting element to have high axial output, and narrowing of the light distribution angle such as described in PTL 3 has also been considered desirable. However, in some devices in which a lens-equipped SMD or the like is used, it may be preferable to increase the light emission output of a light-emitting element in all directions because light emission in directions other than on an axis of the light-emitting element can also effectively be used.

The present disclosure is made in light of these circumstances, and an object thereof is to provide an ultraviolet light-emitting element with which high light emission output is obtained and a method of producing the same.

(Solution to Problem)

The inventor and others conducted diligent and extensive research to achieve the object described above, thereby resulting in completion of the present disclosure set forth below.

Specifically, primary configurations of the present disclosure are as follows.

(1) An ultraviolet light-emitting element comprising:

a transparent substrate having a main surface that constitutes a light extraction surface;
an AlN layer on the transparent substrate;
an n-type semiconductor layer on the AlN layer;
a quantum well-type light-emitting layer on the n-type semiconductor layer;
a p-side semiconductor layer directly on the quantum well-type light-emitting layer; and
a reflective electrode directly on the p-side semiconductor layer, wherein
a side surface of the transparent substrate is a rough surface, and
thickness L (nm) of the p-side semiconductor layer satisfies formula (1), shown below:

$$2L/\cos\theta = \lambda(2k + 1)/2n \cdots (1)$$

with respect to a central emission wavelength $\lambda$, in units of nanometers, of the quantum well-type light emitting layer, a refractive index n of the p-side semiconductor layer, a natural number k, and an emission angle $\theta$ of light traveling toward inside of the p-side semiconductor layer from the quantum well-type light-emitting layer, and is within a range where the emission angle $\theta$ is an angle at which light extraction from the transparent substrate into air would not occur in a case in which the main surface and the side surface of the transparent substrate are flat surfaces.

(2) The ultraviolet light-emitting element according to (1), wherein

the natural number k has a value of 1,
the emission angle $\theta$ is not less than 23.6° and not more than 36.8°, and
an average peak angle of a light distribution pattern according to far field measurement is not less than 24° and not more than 37°.

(3) The ultraviolet light-emitting element according to (1) or (2), wherein
the p-side semiconductor layer includes:

a p-type electron blocking layer on the quantum well-type light-emitting layer;
a p-type cladding layer on the p-type electron blocking layer; and
a p-type contact layer on the p-type cladding layer, and
each layer among the n-type semiconductor layer, the p-type electron blocking layer, and the p-type cladding layer has a uniform composition in a horizontal direction.

(4) The ultraviolet light-emitting element according to (1) or (2), wherein a value determined by dividing thickness of the p-type cladding layer by thickness of the p-type electron blocking layer is 0.4 or more.
(5) A method of producing an ultraviolet light-emitting element comprising:

a step of forming an AlN layer on a surface at an opposite side of a transparent substrate relative to a main surface that constitutes a light extraction surface;
an n-type semiconductor layer formation step of forming an n-type semiconductor layer on the AlN layer;
a quantum well-type light-emitting layer formation step of forming a quantum well-type light-emitting layer on the n-type semiconductor layer;
a p-side semiconductor layer formation step of forming a p-side semiconductor layer directly on the quantum well-type light-emitting layer;
a reflective electrode formation step of forming a reflective electrode directly on the p-side semiconductor layer; and
a segmentation step of segmenting the transparent substrate, wherein
a side surface of the transparent substrate is made a rough surface in the segmentation step, and
the p-side semiconductor layer is formed such that thickness L, in units of nanometers, of the p-side semiconductor layer satisfies formula (1), shown below:

$$2L/\cos\theta = \lambda(2k + 1)/2n \cdots (1)$$

with respect to a central emission wavelength $\lambda$, in units of nanometers, of the quantum well-type light emitting layer, a refractive index n of the p-side semiconductor layer, a natural number k, and an emission angle $\theta$ of light traveling toward inside of the p-side semiconductor layer from the light-emitting layer, and is within a range where

the emission angle $\theta$ is an angle at which light extraction from the transparent substrate into air would not occur in a case in which the main surface and the side surface of the transparent substrate are flat surfaces.

(6) The method of producing an ultraviolet light-emitting element according to (5), wherein the p-side semiconductor layer formation step includes:

a p-type electron blocking layer formation step of forming a p-type electron blocking layer on the quantum well-type light-emitting layer;
a p-type cladding layer formation step of forming a p-type cladding layer on the p-type electron blocking layer; and
a p-type contact layer formation step of forming a p-type contact layer on the p-type cladding layer.

(Advantageous Effect)

According to the present disclosure, it is possible to provide an ultraviolet light-emitting element with which high light emission output is obtained and a method of producing the same.

BRIEF DESCRIPTION OF THE DRAWINGS

In the accompanying drawings:

FIG. 1 is a schematic view illustrating optical paths of light emitted from a quantum well-type light-emitting layer;
FIG. 2 is a schematic view of far field measurement;
FIG. 3 is a schematic view of an ultraviolet light-emitting element according to the present disclosure;
FIG. 4 is an image taken by a profile analysis laser microscope with respect to a side surface of a sapphire substrate in an ultraviolet light-emitting element of Example 1;
FIG. 5 presents light distribution patterns obtained by far field measurement in examples; and
FIG. 6 presents light distribution patterns obtained by far field measurement in comparative examples.

DETAILED DESCRIPTION

The following describes thicknesses of layers in drawings in the present specification prior to describing the present disclosure. Note that ratios of thicknesses of layers are displayed in a modified manner such as to be more clearly visible in the drawings for convenience of description and differ from the actual ratios of thicknesses.

<Thicknesses of layers>

In the present specification, the thickness of each layer of an ultraviolet light-emitting element is measured based on an image taken using a TEM (transmission electron microscope). In other words, an average value of the thickness of each layer in an image taken of a cross-section of an ultraviolet light-emitting element is adopted as the thickness of that layer. Note that the thickness of a transparent substrate is taken to be a value measured using an SEM (scanning electron microscope).

<Measurement of Al composition ratio>

The term "AlGaN" as used in the present specification means $Al_{\alpha}Ga_{1-\alpha}N$ having an Al composition ratio of $\alpha$. The value of the Al composition ratio $\alpha$ of AlGaN in the present disclosure is determined from results of TEM-EDS (energy dispersive X-ray spectroscopy) measurement of a layer cross-section. The Al composition ratio $\alpha$ is within a range of not less than 0 and not more than 1 unless specified otherwise.

Moreover, the terms "GaN" and "AlN" as used in the present specification respectively mean that the composition ratio of Ga is 1.0 and that the composition ratio of Al is 1.0. Note that "GaN", "AlN", and "AlGaN" may contain a trace amount of another group III element not indicated in the chemical formula (inclusive of indium) with a composition ratio of 0.04 or less (mole fraction of 4% or less).

<Measurement of dopant concentration>

Dopant concentrations in the present specification are taken to be values measured by SIMS (secondary ion mass spectrometry). Note that the term "undoped" means that a source gas of a specific dopant such as Mg or Si is not intentionally supplied during MOCVD growth but that impurities such as C, H, and O that are unavoidable in the production process may be included. Moreover, the term "i-type" as used in the present specification means undoped and having a carrier density of $4 \times 10^{16}$ cm$^{-3}$ or less.

(Ultraviolet light-emitting element)

The following provides a detailed description of an ultraviolet light-emitting element (hereinafter, also referred to as a light-emitting element) according to the present disclosure. The ultraviolet light-emitting element according to the present disclosure includes a transparent substrate (hereinafter, also referred to as a substrate) having a light extraction surface, an AlN layer on the transparent substrate, an n-type semiconductor layer on the AlN layer, a quantum well-type light-emitting layer (hereinafter, also referred to as a light-emitting layer) on the n-type semiconductor layer, a p-side semiconductor layer directly on the quantum well-type light-emitting layer, and a reflective electrode directly on the p-side semiconductor layer. The p-side semiconductor layer may include a p-type electron blocking layer on the quantum well-type light-emitting layer, a p-type cladding layer on the p-type electron blocking layer, and a p-type contact layer on the p-type cladding layer. The thickness L (nm) of the p-side semiconductor layer satisfies $2L/\cos\theta = \lambda(2k + 1)/2n$ with respect to a central emission wavelength $\lambda$ (nm) of the quantum well-type light-emitting layer, a refractive index n of the p-side semiconductor layer, a natural number k, and an emission angle $\theta$ of light traveling toward inside of the p-side semiconductor layer from the quantum well-type light-emitting layer, and is within a range where the emission angle $\theta$ is an angle at which light extraction from the transparent substrate into air would not occur (i.e., an angle causing total internal reflection at an interface between the transparent substrate and air) in a case in which a main surface and a side surface of the transparent substrate are flat surfaces (are hypothetically considered to be flat surfaces).

The p-side semiconductor layer is taken to be a layer that may include at least a p-type electron blocking layer on the quantum well-type light-emitting layer, a p-type cladding layer on the p-type electron blocking layer, and a p-type contact layer on the p-type cladding layer, that may further include other configurations, and that may include an undoped layer (for example, a subsequently described i-type guide layer) or a layer doped with an n-type dopant such as Si (for example, a layer doped with just Si or a layer doped with both Si and a p-type dopant (for example, Mg)) with the aim of inhibiting p-type impurity diffusion, for example. In other words, all semiconductor layers that are sandwiched between the quantum well-type light-emitting layer and the reflective electrode are referred to collectively as the p-side semiconductor layer (p-side layer). Note that besides the n-type semiconductor layer, an undoped layer may also be included between the transparent substrate and the quantum well-type light-emitting layer.

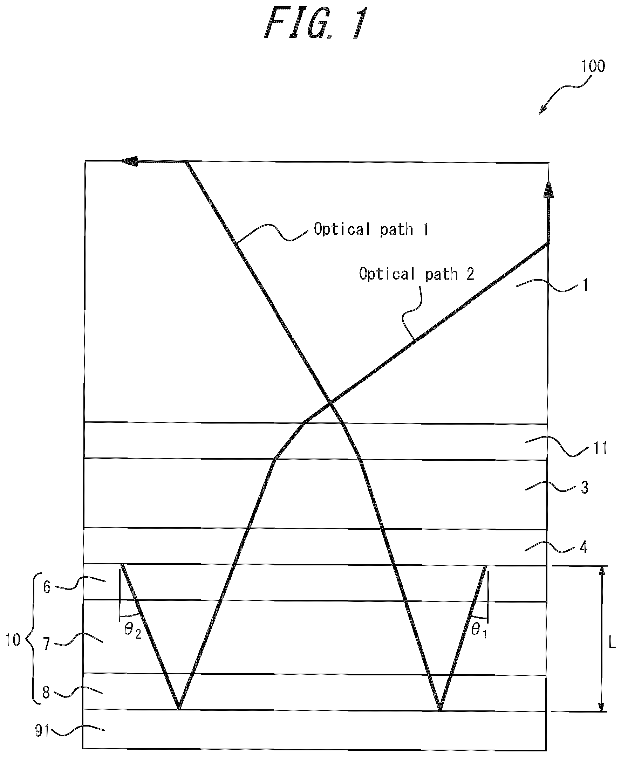

First, the following uses FIG. 1 to describe the circumstances of development of the ultraviolet light-emitting element according to the present disclosure. FIG. 1 is a cross-sectional schematic view that includes a specific configuration for describing paths of light emitted from a quantum well-type light-emitting layer 4 in an ultraviolet light-emitting element 100 according to the present disclosure. The ultraviolet light-emitting element 100 includes, in order from the top: a transparent substrate 1; an AlN layer 11; an n-type semiconductor layer 3; a quantum well-type light-emitting layer 4; a p-side semiconductor layer 10 that includes a p-type electron blocking layer 6, a p-type cladding layer 7, and a p-type contact layer 8; and a reflective electrode 91. The transparent substrate 1 is taken to be a light extraction side of the ultraviolet light-emitting element 100. Since increasing the thickness of the transparent substrate 1 in the ultraviolet light-emitting element 100 increases light extraction surface area inclusive of a side surface of the transparent substrate 1, a thicker transparent substrate 1 has conventionally been considered preferable. It has also been considered preferable for the p-side semiconductor layer 10 and the n-type semiconductor layer 3 to be thicker. FIG. 1 illustrates a rough outline of optical paths of light emitted from the quantum well-type light-emitting layer 4. Light emitted from the quantum well-type light-emitting layer 4 may take an optical path whereby the light is directly extracted externally through the transparent substrate 1 or an optical path whereby the light is reflected by the reflective electrode 91 and is subsequently extracted externally through the transparent substrate 1.

Consider a case in which a main surface and a side surface of the transparent substrate 1 are flat surfaces. In FIG. 1, optical path 1 for light emitted into the p-side semiconductor layer 10 from the quantum well-type light-emitting layer 4 at an emission angle $\theta_1$ illustrates a case in which light is reflected by the reflective electrode 91 and is subsequently incident on a main surface of the transparent substrate 1 at a critical angle (for example, a critical angle upon exiting sapphire into air). In this case, light that is emitted at a smaller angle (i.e., closer to the normal) than the emission angle $\theta_1$ is extracted externally from the main surface of the transparent substrate 1, whereas light that is emitted at a larger angle than $\theta_1$ reaches the main surface at a larger angle than the critical angle, and thus this light undergoes total internal reflection at the main surface and is not extracted from the main surface. In other words, light having an emission angle of $\theta_1$ or more is not extracted at the main surface of the transparent substrate 1.

Moreover, in FIG. 1, optical path 2 for light emitted into the p-side semiconductor layer 10 from the quantum well-type light-emitting layer 4 at an emission angle $\theta_2$ illustrates a case in which light is reflected by the reflective electrode 91 and is subsequently incident on a side surface of the transparent substrate 1 at a critical angle (for example, a critical angle upon exiting sapphire into air). In this case, light that is emitted at a smaller angle than the emission angle $\theta_2$ has an angle larger than the critical angle at the side surface of the transparent substrate 1, and thus is not extracted externally from the side surface, whereas light emitted at a larger angle than the emission angle $\theta_2$ is extracted from the side surface. In other words, light having an emission angle of $\theta_2$ or less is not extracted at the side surface of the transparent substrate 1.

Put another way, in a case in which the main surface and the side surface are flat surfaces and in which total internal reflection according to the critical angle occurs at the interface between the transparent substrate 1 and the outside, light extraction from the transparent substrate 1 is difficult for emission angles of not less than $\theta_1$ and not more than $\theta_2$. Note that $0° < \theta_1 < \theta_2 < 90°$. In a case in which the transparent substrate 1 is sapphire and in which light exits the sapphire into air, the critical angle is calculated to be 33.75 ° by taking the refractive index of sapphire at a wavelength of 340 nm, for example, to be 1.8.

The inventor and others focused on the fact that the light intensity distribution for each light distribution angle (also referred to as a light distribution pattern) remains almost unchanged even when the thickness of the transparent substrate 1 or the n-type semiconductor layer 3 is changed but changes significantly when the thickness of the p-side semiconductor layer 10 is changed, and conducted a detailed investigation of this change. Resonance through multiple reflection is known to occur in the p-side semiconductor layer 10 when the optical path length d (nm) up until light that has been emitted from the quantum well-type light-emitting layer 4 and passed through the p-side semiconductor layer 10 is reflected (fixed end) by the reflective electrode 91 and returns to the quantum well-type light-emitting layer 4 satisfies formula (1), given that $\lambda$ (nm) is the central emission wavelength, n is the refractive index of the p-side semiconductor layer 10, and k is a natural number.

$$d = \lambda(2k + 1)/2n \cdots (1)$$

The optical path length d (nm) is expressed by formula (2) using the thickness L (nm) of the p-side semiconductor layer 10 and the emission angle $\theta$ of light traveling toward inside of the p-side semiconductor layer 10 from the light-emitting layer 4.

$$d = 2L/\cos \theta \cdots (2)$$

The following formula (3) is derived from these formulae (1) and (2).

$$2L/\cos \theta = \lambda(2k + 1)/2n \cdots (3)$$

When the refractive index n of the p-side semiconductor layer 10 is taken to be 2.5, which is a representative refractive index of AlGaN at a wavelength of 340 nm, the central emission wavelength $\lambda$ is taken to be 340 nm, and k is taken to be 1, formula (3) is expressed by the following formula (4).

$$2L/\cos \theta = 204 \text{ nm} \cdots (4)$$

Resonance should arise within a range of combinations of the thickness L (nm) of the p-side semiconductor layer 10 and the emission angle $\theta$ of light traveling toward inside of the p-side semiconductor layer 10 from the light-emitting layer that yield this value.

In FIG. 1, in the case of the critical angle when light travels from AlGaN having a refractive index of 2.5, passes through AlN having a refractive index of 2.3, and is extracted from an interface between sapphire having a refractive index of 1.8 and air having a refractive index of 1, the emission angle $\theta_1$ from the quantum well-type light-emitting layer 4 for the optical path 1 is calculated to be $\theta_1 = 23.6°$, and the emission angle $\theta_2$ from the quantum well-type light-emitting layer 4 for the optical path 2 is calculated to be $\theta_2 = 36.8°$.

When these angles are substituted into the preceding formula (4),

$L_1 = 93.5$ nm yields d = 204 nm when $\theta_1 = 23.6°$, and
$L_2 = 81.7$ nm yields d = 204 nm when $\theta_2 = 36.8°$.

In other words, in a case in which the main surface and the side surface are flat surfaces, when L of the p-side semiconductor layer 10 is thicker than 93.5 nm, resonance should arise at an angle smaller than $\theta_1$ and strong light emission output should occur in light extraction from the main surface.

However, when light emission output and light distribution patterns that were actually obtained with respect to thickness L (nm) of the p-side semiconductor layer 10 were inspected, light emission output was higher when L of the p-side semiconductor layer 10 was 81.7 nm to 93.5 nm as compared to when L of the p-side semiconductor layer 10 was less than 81.7 nm or more than 93.5 nm. In other words, with regard to light that undergoes resonance through multiple reflection in the p-side semiconductor layer 10, a result of increased light emission output was obtained in a situation in which there was resonance in an emission angle θ range where light extraction is theoretically not possible in FIG. 1. Such a result differs from the established theory of increasing light output by exploiting a known interference effect in a normal (film thickness) direction.

Upon inspection of a light-emitting element of an embodiment, a main surface of the transparent substrate 1 was flat to an extent that the opposite side relative to the main surface was visible when the main surface was viewed from directly above, whereas a side surface of the transparent substrate 1 was a rough surface to an extent that another side surface was not visible when the side surface was viewed from the side. The rough surface of the side surface was created during segmentation of the transparent substrate 1. When the side surface is a rough surface, light traveling toward the outside from the side surface of the transparent substrate 1 on the optical path 2 in FIG. 1 is diffusely reflected and externally extracted. The rough surface preferably has an average value of 2 μm or more for arithmetical mean height (Sa). Sa can be determined by measuring the arithmetical mean height (Sa) in accordance with ISO 25178-2:2012 through measurement of surface roughness of the side surface of the transparent substrate 1 using a profile analysis laser microscope (VK-3000 produced by Keyence Corporation), for example. The side surface of the transparent substrate 1 may be an M-plane or an A-plane, and the measurement range should be set in accordance with the thickness of the transparent substrate 1. The measurement range can be set as 300 μm × 300 μm, for example, and an average value of measurements at 4 points, for example, may be calculated.

Therefore, the reason that light emission output increases when the thickness of the p-side semiconductor layer 10 is not less than $L_2$ and not more than $L_1$ is thought to be that in this thickness range for the p-side semiconductor layer 10, light for which the emission angle of emitted light from the quantum well-type light-emitting layer 4 is within a range of not less than $\theta_1$ and not more than $\theta_2$ (i.e., light that would not be extracted externally from the sapphire substrate in a case in which the main surface and the side surface are flat surfaces) undergoes resonance through multiple reflection in the p-side semiconductor layer 10, reaches the rough side surface, and is extracted, thus resulting in higher light emission output.

In this manner, total output of the ultraviolet light-emitting element 100 is thought to increase as a light component that is extracted from a side surface (rough surface) of the transparent substrate 1 increases. Moreover, as described further below, a light distribution pattern of light emission output has a characteristic shape in which a peak is present at a position separated from an axial direction and in which light emission output is relatively low in the axial direction. Phrased the other way around, by adopting an ultraviolet light-emitting element that has a light distribution pattern having an average peak angle such that a relationship of light intensity of a main surface and a side surface of a transparent substrate 1 is as described below, it is possible to improve light emission output.

<Average peak angle of light distribution pattern according to far field measurement>

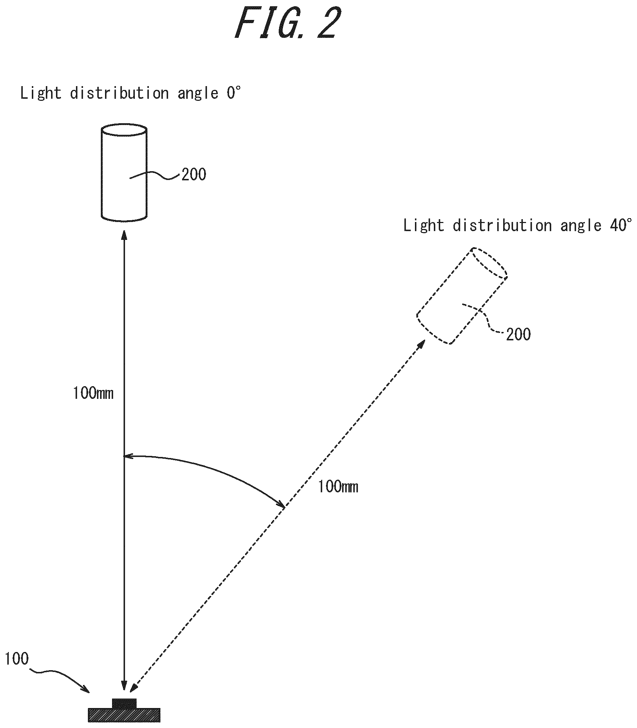

The following describes an average peak angle of a light distribution pattern according to far field measurement with reference to a schematic view of far field measurement in FIG. 2. First, in far field measurement, the position of a light-receiving element 200 that is arranged on an extension of a normal axis along a substrate growth direction of a light-emitting element 100 in a dark room is taken to be a light distribution angle 0°. The position of the light-receiving element 200 relative to the light-emitting element 100 is rotated from -90° such as to pass through a position of 0° and is then rotated to a position of +90°. The light emission intensity received by the light-receiving element 200 at each angle during this rotation is measured and is illustrated in a diagrammatic manner to obtain a light distribution pattern. In this measurement, the diameter of a light-receiving section of the light-receiving element 200 can be set as 3.9 mm, the distance between the light-emitting element 100 and the light-receiving element 200 can be set as 100 mm, and measurement can be performed in a state in which the light-emitting element 100 is mounted on a submount made of AlN by a flip chip method using spherical Au bumps.

In the light distribution pattern of the light-emitting element 100 obtained through far field measurement, an angle at which light emission intensity is greatest at each of the negative side and the positive side is referred to as a peak angle.

Moreover, the main surface (xy plane) of the light-emitting element 100 is rotated 45° three times from an orientation of 0° with a normal axis (z-axis) along the substrate growth direction at the center of the light-emitting element 100 (square in plan view) as a center of rotation so as to make a total of 4 measurements and obtain light distribution patterns for 4 orientations (in two of these orientations, a side of the main surface of the square light-emitting element 100 and a rotation axis of the light-receiving element 200 in far field measurement are horizontal). The average peak angle is taken to be an average value of a total of 8 peak angles that are determined by determining an angle at which light emission intensity is highest at each of a positive side and a negative side in each of the light distribution patterns for the 4 orientations.

In the present disclosure, light emission output can be significantly improved through the average peak angle of a light distribution pattern according to far field measurement being not less than 24° and not more than 37°. The average peak angle is more preferably not less than 27° and not more than 36°, and even more preferably not less than 30° and not more than 35°. The reason for this is that a larger light component is extracted from the rough side surface of the transparent substrate 1 as previously described.

<Composition uniformity>

In the present disclosure, it is preferable that the n-type semiconductor layer 3, the p-type electron blocking layer 6, and the p-type cladding layer 7 have a uniform composition in a horizontal direction. Analysis of composition is performed through continuous compositional analysis by EDS with respect to a range having a length of not less than 2 $\mu$m and not more than 3 $\mu$m in a horizontal direction (direction horizontal with the transparent substrate surface) near a thickness center of a cross-section. The phrase "uniform composition in a horizontal direction" means that a value obtained when the difference between a maximum value and a minimum value for a band gap calculated in an Al composition ratio for the analysis range is divided by the maximum value (= (max. value - min. value)/max. value); hereinafter, referred to as a "ratio of horizontal direction composition fluctuation") is 4.8% or less. A uniform composition in a horizontal direction is thought to facilitate resonance of light described above.

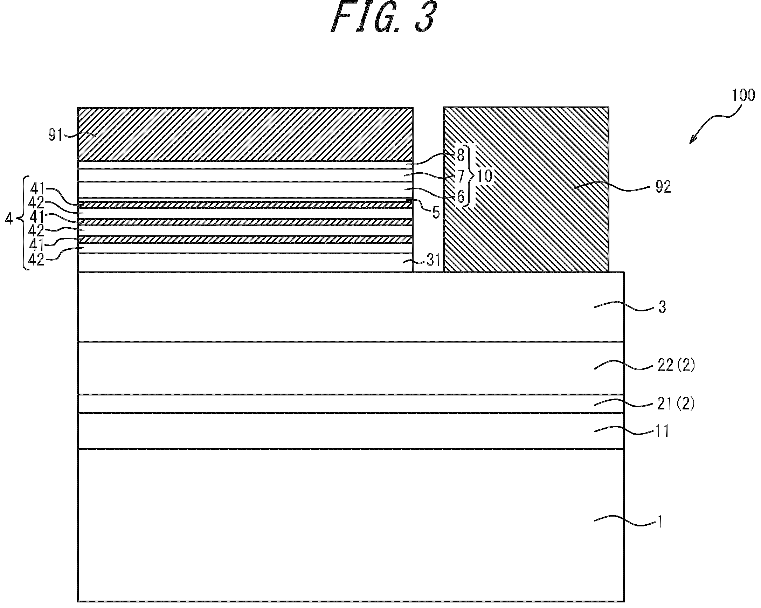

The following refers to FIG. 3 to describe the ultraviolet light-emitting element 100 and method of producing the same according to the present disclosure with specific configurations. FIG. 3 illustrates one example of an ultraviolet light-emitting element produced by the method of producing an ultraviolet light-emitting element according to the present disclosure. Note that MOCVD can be adopted as the method of epitaxial growth of each semiconductor layer. Source gases including trimethylaluminum gas (TMA gas), trimethylgallium gas (TMG gas), and ammonia gas (NH$_3$ gas) are preferably used in epitaxial growth of each layer. The growth temperature is dependent on the Al composition ratio but is preferably not lower than 1000°C and not higher than 1400°C. Moreover, the growth pressure inside of a chamber can be set as 10 Torr to 760 Torr, for example. The flow rates of the source gases are preferably set as appropriate in order that there is a molar ratio of group V element relative to group III element (V/III ratio) that is optimal according to the growth temperature and the growth pressure.

(Method of producing ultraviolet light-emitting element)

The following refers to FIG. 3. The method of producing the ultraviolet light-emitting element 100 includes at least a step of forming an AlN layer 11 on a surface at an opposite side of a transparent substrate 1 relative to a main surface that constitutes a light extraction surface, an n-type semiconductor layer formation step of forming an n-type semiconductor layer 3 on the AlN layer 11, a quantum well-type light-emitting layer formation step of forming a quantum well-type light-emitting layer 4 on the n-type semiconductor layer 3, a p-side semiconductor layer formation step of forming a p-side semiconductor layer 10 directly on the quantum well-type light-emitting layer 4, a reflective electrode formation step of forming a reflective electrode 91 directly on the p-side semiconductor layer 10, and a segmentation step of segmenting the transparent substrate 1. Moreover, the p-side semiconductor layer formation step preferably includes a p-type electron blocking layer formation step of forming a p-type electron blocking layer 6 on the quantum well-type light-emitting layer 4, a p-type cladding layer formation step of forming a p-type cladding layer 7 on the p-type electron blocking layer 6, and a p-type contact layer formation step of forming a p-type contact layer 8 on the p-type cladding layer 7. Furthermore, the p-side semiconductor layer 10 is formed such that the thickness L (nm) of the p-side semiconductor layer 10 satisfies $2L/\cos\theta = \lambda$ (2k + 1)/2n with respect to a central emission wavelength $\lambda$ (nm) of the quantum well-type light-emitting layer 4, a refractive index n of the p-side semiconductor layer 10, a natural number k, and an emission angle $\theta$ of light traveling toward inside of the p-side semiconductor layer 10 from the quantum well-type light-emitting layer 4, and is within a range where the emission angle $\theta$ is an angle at which extraction of light from the main surface into air would not occur in a case in which the main surface and a side surface of the transparent substrate 1 are flat surfaces. Note that in the present disclosure, the AlN layer 11 is preferably formed on the transparent substrate 1. Moreover, in the method of producing the ultraviolet light-emitting element 100, it is preferable that a buffer layer 2 is formed between the transparent substrate 1 and the n-type semiconductor layer 3, and it is also preferable that the buffer layer 2 includes a first buffer layer 21 and a second buffer layer 22 in order from the substrate. Furthermore, it is preferable that an i-type guide layer 5 is formed on the light-emitting layer 4. Configurations in the various steps are described below in order.

<Transparent substrate>

First, the transparent substrate 1 is prepared. The transparent substrate 1 can be a commonly known substrate that is transparent with respect to the central emission wavelength, that has a light extraction surface, and on which epitaxial growth of a group III nitride is possible. For example, a sapphire substrate, an AlN bulk substrate, or an AlGaN substrate can be used. A main surface at an opposite side of the transparent substrate 1 to the reflective electrode 91 side and a side surface of the transparent substrate 1 are light extraction surfaces. In the present disclosure, a case in which the transparent substrate 1 is a sapphire substrate is described below as an example.

In a case in which a sapphire substrate is used as the transparent substrate 1, it is more preferable to use an AlN template substrate that is obtained by forming an AlN layer 11 on the transparent substrate 1 as illustrated in FIG. 3 and heat treating the AlN layer 11 at high temperature so as to reduce dislocations until the full width at half maximum of an X-ray rocking curve for (10-12) planes of the AlN layer 11 is 400 seconds or less. In the following description, a product obtained by forming the AlN layer 11 on the transparent substrate 1 is referred to as an AlN template substrate.

<Buffer layer>

It is preferable that a buffer layer 2 is formed on the AlN template substrate. The buffer layer 2 is a layer that is located between the AlN layer 11 on the transparent substrate 1 and the n-type semiconductor layer 3 and that eases a lattice constant difference between the n-type semiconductor layer 3 and the transparent substrate 1 and AlN layer 11. The buffer layer 2 is preferably a single AlGaN layer having a constant Al composition ratio, a layer resulting from stacking of a plurality of AlGaN layers having different Al composition ratios, or an Al composition ratio gradient layer. Moreover, the buffer layer 2 is preferably undoped. The thickness of the buffer layer 2 is preferably not less than 500 nm and not more than 2,000 nm, for example.

The buffer layer 2 may be a layer resulting from stacking of a first buffer layer 21 and a second buffer layer 22 that are AlGaN layers having different Al composition ratios to each other.

<n-Type semiconductor layer>

The n-type semiconductor layer 3 is a layer that contains an n-type dopant such as Si in $Al_xGa_{1-x}N$ having an Al composition ratio x and that functions as an n-type semiconductor. The concentration of the n-type dopant is preferably approximately $1 \times 10^{18}$ cm$^{-3}$ to $5 \times 10^{19}$ cm$^{-3}$. In one example of the n-type semiconductor layer formation step, after the buffer layer 2 has been formed on the AlN template substrate, the n-type semiconductor layer 3 is formed at a surface side of the buffer layer 2 that is an opposite side relative to a surface at a side facing toward the AlN template substrate.

The Al composition ratio x of the n-type semiconductor layer 3 is preferably not less than 0.20 and not more than 0.35. The Al composition ratio x is larger than the subsequently described Al composition ratio w of well layers 41 and satisfies a relationship w < x.

The thickness of the n-type semiconductor layer 3 should be sufficiently thick for supplying carriers and is preferably not less than 300 nm and not more than 3,000 nm, for example.

As described further below, an n-side electrode 92 is formed on part of the n-type semiconductor layer 3 after exposure thereof. In a modified example, an AlGaN layer having an Al composition ratio of not less than 0 and not more than 0.20 that is lower than the Al composition ratio of the n-type semiconductor layer 3 may be present between the n-type semiconductor layer 3 and the n-side electrode 92.

An n-type guide layer 31 that is thinner than the n-type semiconductor layer 3 and that is a layer that functions as an n-type semiconductor containing an n-type dopant such as Si in AlGaN having the same Al composition ratio as the n-type semiconductor layer 3 may be formed on the n-type semiconductor layer 3.

<Quantum well-type light-emitting layer>

The quantum well-type light-emitting layer 4 is a layer that includes a plurality of well layers 41 and a plurality of barrier layers 42 and in which these layers are stacked alternately. The quantum well-type light-emitting layer 4 may be a layer that includes layers formed of AlGaN, for example. In other words, the quantum well-type light-emitting layer 4 can have a configuration that includes well layers 41 having an Al composition ratio in accordance with the central emission wavelength and barrier layers 42 sandwiching the well layers 41 and in which one or more pairs that are each a combination of a well layer 41 and a barrier layer 42 are repeated. Both surfaces of the quantum well-type light-emitting layer 4 are barrier layers 42. In one example of the quantum well-type light-emitting layer formation step, after the n-type semiconductor layer 3 has been formed, the quantum well-type light-emitting layer 4 is formed at a surface side of the n-type semiconductor layer 3 that is an opposite side relative to a surface at a side facing toward the AlN template substrate.

The well layers 41 in the present disclosure may be layers formed of $Al_wGa_{1-w}N$ having an Al composition ratio w, for example. The Al composition ratio w is preferably set as $w \le 0.35$ in a case in which the central emission wavelength is to be set as more than 300 nm, for example. The Al composition ratio w is preferably set as $w \le 0.30$ in a case in which the central emission wavelength is to be set as more than 320 nm, for example. Moreover, the Al composition ratio w is preferably set as $w \le 0.15$ in a case in which the central emission wavelength is to be set as 331 nm or more. Furthermore, the Al composition ratio w is preferably set as $0.07 \le w$ in a case in which the central emission wavelength is to be set as 349 nm or less. The thickness of the well layers 41 is preferably set as not less than 1 nm and not more than 5 nm. The well layers 41 are preferably undoped.

The barrier layers 42 may be layers formed of $Al_bGa_{1-b}N$ having an Al composition ratio b, for example. The Al composition ratio b of the barrier layers 42 is preferably within a range of $w + 0.05 \le b \le w + 0.30$ relative to the Al composition ratio w of the well layers 41. The thickness of the barrier layers 42 is preferably set as not less than 3 nm and not more than 20 nm. The barrier layers 42 may be undoped or may be of an n-type doped with an n-type dopant such as Si.

The central emission wavelength of the ultraviolet light-emitting element 100 according to the present disclosure can be set as not less than 250 nm and not more than 360 nm, is preferably set as more than 300 nm and less than 350 nm, and is more preferably set as not less than 331 nm and not more than 349 nm. Examples of calculated values for the thickness L of the p-side semiconductor layer 10 determined by formula (1) according to the present disclosure for when adopted for various central emission wavelengths according to the present disclosure are shown in Table 1. The thickness is shown with cases of the optical path 1 and the optical path 2 in FIG. 1 described above as an upper limit and a lower limit for the thickness using the optical path length d (at which resonance arises) when the refractive index n of the p-side semiconductor layer 10 is 2.5, which is a representative refractive index of AlGaN, and when k = 1.

[Table 1]

| Wavelength $\lambda$ | Optical path length d | Thickness L of p-side semiconductor layer | |
| --- | --- | --- | --- |
| | | Upper limit $L_1$ ($\theta_1$ = 23.6°) | Lower limit $L_2$ ($\theta_2$ = 36.8°) |
| nm | nm | nm | nm |
| 250 | 150 | 68.7 | 60.1 |
| 260 | 156 | 71.5 | 62.5 |
| 270 | 162 | 74.2 | 64.9 |
| 280 | 168 | 77.0 | 67.3 |
| 290 | 174 | 79.7 | 69.7 |
| 300 | 180 | 82.5 | 72.1 |
| 310 | 186 | 85.2 | 74.5 |
| 320 | 192 | 88.0 | 76.9 |
| 330 | 198 | 90.7 | 79.3 |
| 340 | 204 | 93.5 | 81.7 |
| 350 | 210 | 96.2 | 84.1 |

<i-Type guide layer>

The i-type guide layer 5 is an i-type layer that has a higher Al composition ratio than the Al composition ratio b of the barrier layers 42 and that has a thickness of not less than 0.7 nm and not more than 1.3 nm. It is preferable that the Al composition ratio of the i-type guide layer 5 is higher than the subsequently described Al composition ratio y of the p-type electron blocking layer 6, and most preferable that the i-type guide layer 5 is AlN. In one example of the light-emitting layer formation step, after the light-emitting layer 4 has been formed, the i-type guide layer 5 is formed at a surface side of the light-emitting layer 4 that is an opposite side relative to a surface at a side facing toward the AlN template substrate.

There are two types of production methods for the i-type guide layer 5. One method involves directly forming an i-type guide layer 5 having the thickness and Al composition described above. The other method involves forming an AlGaN layer having a thickness of not less than the above-described thickness and then changing a carrier gas from nitrogen to hydrogen. In the process of the carrier gas changing from nitrogen to hydrogen, reduction of the nitrogen partial pressure causes volatilization of Ga from the AlGaN layer and increases the Al composition, thereby enabling the formation of an i-type guide layer 5 having the thickness and Al composition described above. Either of these methods can be adopted in the present disclosure.

<p-Type electron blocking layer>

The p-type electron blocking layer 6 may be a layer that functions as a p-type semiconductor formed of $Al_yGa_{1-y}N$ having an Al composition ratio y, for example. A p-type dopant (p-type impurity) with which the p-type electron blocking layer 6 is doped may be Mg, for example. The concentration of the p-type dopant may be approximately $1 \times 10^{18}$ cm$^{-3}$ to $5 \times 10^{19}$ cm$^{-3}$, for example. After the i-type guide layer 5 has been formed, the p-type electron blocking layer 6 can be formed at a surface side of the i-type guide layer 5 that is an opposite side relative to a surface at a side facing toward the AlN template substrate.

In a case in which the p-type electron blocking layer 6 is $Al_yGa_{1-y}N$, the Al composition ratio y is preferably not less than 0.35 and not more than 0.45, and the thickness is preferably not less than 11 nm and not more than 70 nm. When the p-type electron blocking layer 6 has an Al composition ratio y and a thickness such as described above, deterioration of surface roughness of the p-type electron blocking layer 6 can be suppressed while also enabling the p-type electron blocking layer 6 to fulfill its role as an electron blocking layer and realizing improvement of light emission output. In order to improve light emission output, it is even more preferable that the p-type electron blocking layer 6 is thinner than the subsequently described p-type cladding layer 7.

In a case in which the Al composition ratio y exceeds 0.45 or the thickness of the p-type electron blocking layer 6 exceeds 70 nm, this may significantly increase the surface roughness of the p-type electron blocking layer 6 and the p-type contact layer 8, and particularly the maximum surface roughness thereof. In a case in which the Al composition ratio y is less than 0.35 or the thickness of the p-type electron blocking layer 6 is not more than 10 nm or exceeds 70 nm, this may reduce reliability or light emission output of the ultraviolet light-emitting element 100.

The p-type electron blocking layer 6 may be a single layer or may be a plurality of layers. In a case in which the p-type electron blocking layer 6 is a plurality of layers, the p-type electron blocking layer 6 may include layers having different Al composition ratios, layers having different dopant concentrations, a layer doped with Si, and/or a layer co-doped with Si and Mg.

<p-Type cladding layer>

The p-type cladding layer 7 may be a layer that functions as a p-type semiconductor formed of $Al_zGa_{1-z}N$ having an Al composition ratio z, for example. In a case in which the p-type cladding layer 7 is $Al_zGa_{1-z}N$, the Al composition ratio z is preferably not less than 0.17 and not more than 0.27. A p-type dopant with which the p-type cladding layer 7 is doped may be Mg, for example. The concentration of the p-type dopant may be approximately $1 \times 10^{18}$ cm$^{-3}$ to $5 \times 10^{19}$ cm$^{-3}$, for example. In one example of the p-type cladding layer formation step, after the p-type electron blocking layer 6 has been formed, the p-type cladding layer 7 is formed at a surface side of the p-type electron blocking layer 6 that is an opposite side relative to a surface at a side facing toward the AlN template substrate.

The Al composition ratio z of the p-type cladding layer 7 is preferably less than the Al composition ratio y of the p-type electron blocking layer 6 (i.e., z < y). The Al composition ratio z of the p-type cladding layer 7 is preferably set as not less than 0.48 times and not more than 0.6 times the Al composition ratio y of the p-type electron blocking layer 6. Moreover, the Al composition ratio z is preferably not more than the Al composition ratio x of the n-type semiconductor layer 3 (i.e., $z \leq x$). The Al composition ratio z is larger than the previously described Al composition ratio w of the well layers 41 (i.e., w < z).

The thickness of the p-type cladding layer 7 is set in accordance with the thicknesses of other layers in the p-side semiconductor layer 10 (for example, the p-type electron blocking layer 6, the i-type guide layer 5, and the p-type contact layer 8) so as to satisfy the previously described formula (1).

The p-type cladding layer 7 may be a single layer, may be a plurality of layers, or may be a composition gradient layer. In a case in which the cladding layer 7 is a plurality of layers, the cladding layer 7 may include layers having different Al composition ratios, layers having different dopant concentrations, a layer doped with Si, and/or a layer co-doped with Si and Mg. In a case in which the cladding layer 7 is a composition gradient layer, the Al composition ratio of the p-type cladding layer may be caused to decrease gradually from the electron blocking layer toward the p-type contact layer 8. The method by which the Al composition ratio is caused to decrease gradually may be a commonly known method, and the Al composition ratio may be changed even for a fixed proportion relative to the film thickness.

A value determined when the thickness of the p-type cladding layer 7 is divided by the thickness of the p-type electron blocking layer 6 (hereinafter, also referred to as a layer thickness ratio) is preferably 0.4 or more. In order to improve light emission output, the layer thickness ratio is more preferably 0.5 or more, and even more preferably 1.0 or more. The upper limit for the layer thickness ratio can be set as 8.0. A layer thickness ratio of less than 0.4 tends to result in deterioration of surface flatness of the p-type cladding layer 7.

<p-Type contact layer>

The p-type contact layer 8 is a layer that functions as a p-type semiconductor formed of $Al_cGa_{1-c}N$ having an Al composition ratio c. An Al composition ratio c of 0.15 or less is preferable, and GaN is most preferable. A p-type dopant with which the p-type contact layer 8 is doped may be Mg, for example. The concentration of the p-type dopant may be approximately $1 \times 10^{19}$ cm$^{-3}$ to $5 \times 10^{21}$ cm$^{-3}$. In one example of the p-type contact layer formation step, after the p-type cladding layer 7 has been formed, the p-type contact layer 8 is formed at a surface side of the p-type cladding layer 7 that is an opposite side relative to a surface at a side facing toward the AlN template substrate.

The thickness of the p-type contact layer 8 is preferably 15 nm or less. The thickness of the p-type contact layer 8 is more preferably not less than 3 nm and not more than 10 nm. By setting the p-type electron blocking layer 6 and the p-type cladding layer 7 as described above, it is possible to provide the p-type contact layer 8 with a flat surface even when the p-type contact layer 8 is a thin layer such as described above.

The p-type contact layer 8 may be a single layer or may be a plurality of layers. In a case in which the p-type contact layer 8 is a plurality of layers, the p-type contact layer 8 may include layers having different Al composition ratios, layers having different dopant concentrations, a layer doped with Si, and/or a layer co-doped with Si and Mg.

The total thickness of the p-side semiconductor layer 10 that is formed between the quantum well-type light-emitting layer 4 and the reflective electrode 91 in this manner is preferably not less than 85 nm and not more than 100 nm in a case in which the central emission wavelength is 340 nm. In setting of the average peak angle of a light distribution pattern according to far field measurement within the previously described range, the total thickness of the p-side semiconductor layer 10 is thought to influence extraction of light from a side surface of the light-emitting element 100 when light traveling toward the p-side semiconductor layer 10 returns toward the transparent substrate 1 side due to the reflective electrode 91 as has already been described.

It is preferable that a high p-type dopant concentration region where the concentration of the p-type dopant is approximately $1 \times 10^{20}$ cm$^{-3}$ to $5 \times 10^{21}$ cm$^{-3}$ is included at the outermost surface of the p-type contact layer 8 at a side where the p-side reflective electrode 91 is formed.

<Reflective electrode>

A commonly known electrode that can be used with the p-type contact layer 8 may be selected as the reflective electrode 91. The reflective electrode 91 is preferably a reflective electrode having a reflectance of 50% or more at the central emission wavelength. A combination of a first metal (Ni) and a second metal (Au, Rh) or a conductive metal nitride, for example, can be used as the reflective electrode 91. In a case in which the reflective electrode 91 is to be a reflective electrode, it is preferable that the reflective electrode 91 contains Rh. In one example of the reflective electrode formation step, the reflective electrode 91 is formed on the p-type contact layer 8 (on a surface of the p-type contact layer 8 at an opposite side relative to a surface at a side facing toward the AlN template substrate).

<n-Type electrode>

In a case in which the light-emitting element 100 is to be a flip chip-type light-emitting element, dry etching may be performed to cause partial removal of a section above the n-type semiconductor layer 3 from the n-type guide layer 31 and the light-emitting layer 4 up to the p-type contact layer 8 and thereby expose part of the n-type semiconductor layer 3, and then an n-side electrode 92 may be formed on part of the n-type semiconductor layer 3 that has been exposed (on a surface at the same side as the light-emitting layer 4 in the present disclosure) as illustrated in FIG. 3. Note that in a modified example, after part of the n-type semiconductor layer 3 has been exposed, a layer that is formed of AlGaN having an Al composition ratio of not less than 0 and not more than 0.20 that is lower than the Al composition ratio of the n-type semiconductor layer 3 and that is doped with a n-type dopant may be formed on the exposed n-type semiconductor layer 3, and then an n-side electrode 92 may be formed on this layer.

A commonly known electrode that can be used with the p-type contact layer 8 may be selected as the n-side electrode 92. A combination of a first metal (Ti) and a second metal (Al, Rh) or a conductive metal oxide, for example, can be used as the n-side electrode 92.

The ultraviolet light-emitting element 100 illustrated in FIG. 3 that has been produced in this manner includes, in stated order on a transparent substrate 1 having a light extraction surface, an AlN layer 11, a buffer layer 2, an n-type semiconductor layer 3 formed of $Al_xGa_{1-x}N$ having an Al composition ratio x, an n-type guide layer 31, a quantum well-type light-emitting layer 4, an i-type guide layer 5, a p-type electron blocking layer 6 formed of $Al_yGa_{1-y}N$ having an Al composition ratio y, a p-type cladding layer 7 formed of $Al_zGa_{1-z}N$ having an Al composition ratio z, and a p-type contact layer 8.

In addition to these configurations, the light-emitting element 100 may include a reflective electrode 91 (also referred to as a p-side electrode) on a surface of the p-type contact layer 8 at an opposite side relative to a surface at a side facing toward the p-type cladding layer 7 and may include an n-side electrode 92 on another region of the n-type semiconductor layer 3 to a surface where the light-emitting layer 4 is formed.

The above has described details of the light-emitting element 100. So long as the light-emitting element 100 has a rough side surface as a result of segmentation, any method can be adopted in the step of segmentation from a wafer. In segmentation of chips of individual light-emitting elements 100 from the wafer, it is preferable that each layer on the substrate is removed by dry etching or the like at a planned separation position. A mesa (inclined section) may be formed at the side surface of each layer during the above. The chip size of the light-emitting element 100 can be a square, rectangle, or hexagon having a side length of 200 μm to 2,000 μm. Segmentation of the substrate is preferably performed by a laser scriber or laser dicing, and it is also preferable that the focal position of the laser is shifted by a small amount in a direction along a planned cutting line and in a depth direction during laser irradiation so as to form many deformed sections and that stress is applied in splitting in order to form a rough side surface through the deformed sections exposed at the cut surface. The substrate is preferably cut perpendicularly relative to the main surface. The thickness of the substrate may be adjusted through grinding or the like prior to segmentation. As previously described, a side surface of the transparent substrate 1 is roughened in the segmentation step to an extent that another side surface is not visible upon observation of the side surface from the side. The main surface of the transparent substrate 1 is a flat surface to an extent that the previously described electrode, etc. are visible through the transparent substrate 1 in plan view.

In another embodiment of the light-emitting element 100, the light-emitting element 100 may be a vertical-type element. A vertical-type element can be obtained by a method in which a conductive substrate serving as a transparent substrate 1 having a light extraction surface is used as an epitaxial growth substrate.

Note that the embodiments disclosed in the present specification are illustrative examples and that embodiments of the present disclosure are not limited thereto. Various alterations can be made to the extent that they do not deviate from the object of the present disclosure.

EXAMPLES

The following describes the light-emitting element 100 according to the present disclosure through examples.

(Example 1)

A sapphire substrate (diameter: 2 inches; thickness: 430 $\mu$m; orientation: (0001); m-axis direction off-angle $\theta$: 0.5°) was prepared, and an AlN layer having a film thickness of 600 nm at the wafer center was grown on the sapphire substrate by MOCVD with a growth temperature of 1200°C. Thereafter, 4 hours of heating was performed at 1650°C in a nitrogen gas atmosphere using a heat treatment furnace to obtain an AlN template substrate.

The full width at half maximum of a (10-12) X-ray rocking curve measured by an X-ray diffractometer (D8 DISCOVER AUTOWAFS produced by Bruker AXS; Cu K$\alpha$1 line) with respect to the AlN layer of the AlN template substrate was 288 seconds, and thus was 300 seconds or less.

Upon measurement of the surface roughness of the AlN template substrate in a 5 $\mu$m $\times$ 5 $\mu$m square range at the center of the wafer using an AFM (atomic force microscope), the average surface roughness (Ra) was 0.23 nm and the maximum surface roughness (Rmax) was 3 nm.

After the AlN template substrate had been obtained, MOCVD was used to form a first buffer layer of 30 nm in thickness that was formed of undoped $Al_{0.40}Ga_{0.60}N$ on the AlN template substrate and then to form a second buffer layer of 1,000 nm in thickness that was formed of undoped $Al_{0.25}Ga_{0.75}N$.

Next, an n-type semiconductor layer of 2,400 nm in thickness that was doped with Si was formed on the second buffer layer. The Si concentration of the n-type semiconductor layer was determined to be $1.0 \times 10^{19}$ atoms/cm$^3$ as a result of SIMS analysis.

The n-type semiconductor layer had a uniform composition with a ratio of composition fluctuation in a horizontal direction of 2.7%.

Next, the growth temperature was changed from 1200°C to 1100°C, and then an n-type guide layer of 25 nm in thickness that was formed of Si-doped $Al_{0.25}Ga_{0.75}N$ was formed on the n-type semiconductor layer. Next, a light-emitting layer having a quantum well structure was formed through three repetitions of formation of a barrier layer of 12 nm in thickness that was formed of Si-doped $Al_{0.25}Ga_{0.75}N$ and a well layer of 2.4 nm in thickness that was formed of undoped $Al_{0.10}Ga_{0.90}N$.

Thereafter, an i-type guide layer of 3 nm in thickness that was formed of undoped $Al_{0.25}Ga_{0.75}N$ was formed on the light-emitting layer (on the third well layer). Supply of group III source gas was subsequently suspended while continuing supply of group V source gas. Nitrogen gas as a carrier gas was suspended, and the carrier gas was changed to hydrogen gas. At 1 minute after the start of supply of hydrogen gas, supply of group III source gas was started, and a p-type electron blocking layer of 22 nm in thickness that was formed of Mg-doped $Al_{0.4}Ga_{0.6}N$ was formed. Next, a p-type cladding layer of 64 nm in thickness that was formed of Mg-doped $Al_{0.22}Ga_{0.78}N$ was formed, and then a p-type contact layer (p-type GaN contact layer) of 4 nm in thickness that was formed of Mg-doped GaN was formed. In accompaniment to the change of carrier gas described above, the i-type guide layer underwent volatilization and decomposition of a Ga component and thereby changed to an i-type guide layer of 1.0 nm in thickness that had an Al composition ratio of roughly 1. The total film thickness of the p-type blocking layer and the p-type cladding layer combined was 86 nm. The total thickness L of the p-side semiconductor layer above the light-emitting layer, inclusive of the i-type guide layer and the p-type contact layer, was 91 nm.

The Mg concentrations of the p-type electron blocking layer, the p-type cladding layer, and the p-type contact layer were respectively determined to be $1.0 \times 10^{19}$ atoms/cm$^3$, $5.0 \times 10^{19}$ atoms/cm$^3$, and $2.0 \times 10^{20}$ atoms/cm$^3$ as a result of SIMS analysis. The p-type electron blocking layer and the p-type cladding layer each had a uniform composition with a ratio of composition fluctuation in a horizontal direction of 4.2%.

The Al composition ratio, dopant type, and thickness of each layer in Example 1 are shown in Table 2. Measured values for thickness shown in Table 2 are based on measurement results obtained using a TEM. The Al composition ratio of each layer is determined through TEM-EDS measurement of a cross-section of that layer.

[Table 2]

| Semiconductor layer | Al composition ratio | Dopant | Thickness nm |
|---|---|---|---|
| p-Type contact layer | 0 | Mg | 4 |
| p-Type cladding layer | 0.22 | Mg | 64 |
| p-Type electron blocking layer | 0.4 | Mg | 22 |
| i-Type guide layer | 1 | - | 1 |
| Well layer | 0.1 | - | 2.4 |
| Barrier layer | 0.25 | Si | 12 |
| Well layer | 0.1 | - | 2.4 |
| Barrier layer | 0.25 | Si | 12 |
| Well layer | 0.1 | - | 2.4 |
| Barrier layer | 0.25 | Si | 12 |
| n-Type guide layer | 0.25 | Si | 25 |
| n-Type semiconductor layer | 0.25 | Si | 2400 |
| Second buffer layer | 0.25 | - | 1000 |
| First buffer layer | 0.4 | - | 35 |
| AlN layer | 1 | - | 600 |
| Sapphire substrate | - | - | 430 ($\mu$m) |

Furthermore, a mask was formed on the p-type contact layer, and mesa etching was performed by dry etching to expose part of the n-type semiconductor layer. The mask on the p-type contact layer was subsequently removed.

Next, a Ni layer of 7 nm in thickness and a Rh layer of 50 nm in thickness were formed on the p-type contact layer so as to form a reflective electrode as a p-side electrode.

In addition, a Ti layer of 20 nm in thickness and an Al layer of 150 nm in thickness were formed as an n-type electrode on the exposed part of the n-type semiconductor layer described above so as to form an n-type electrode.

Stacking of the p-side electrode and the n-type electrode was performed by sputtering. Formation of electrode patterns of the p-side electrode and the n-type electrode was performed by a lift-off method using a resist.

Moreover, an infrared lamp annealing heating device was used to perform 10 minutes of contact annealing at 550°C. Thereafter, individual elements having a square shape with a chip size of 1,000 $\mu$m $\times$ 1,000 $\mu$m were separated using a laser scriber to produce an ultraviolet light-emitting element according to Example 1. In the laser scriber, the focus position of the laser was shifted by a small amount in a direction along a planned cutting line and a depth direction so as to form deformed sections in 11 dotted line shapes and such that a side surface of the sapphire substrate after separation was rough. The side surface of the sapphire substrate is perpendicular relative to the main surface thereof. The thickness of the sapphire substrate after element separation was 430 $\mu$m.

With respect to the side surface of the sapphire substrate after separation, a profile analysis laser microscope (VK-X3000 produced by Keyence Corporation) was used to measure the surface roughness of the surface and calculate an average value of the surface roughness. The measurement conditions were as follows.

- Measurement range: 300 $\mu$m $\times$ 300 $\mu$m (measured with center of measurement range matched to center of side surface)
- Lens magnification: $\times$ 10
- Number of pixels: 1024 $\times$ 768

Specific input parameters for the surface roughness measurement apparatus were as follows.

- Sxp: p = 2.5%
- Vvv: p = 80.0%
- Vvc: p = 10.0%, q = 80.0%

- Vmp: p = 10.0%
- Vmc: p = 10.0%, q = 80.0%

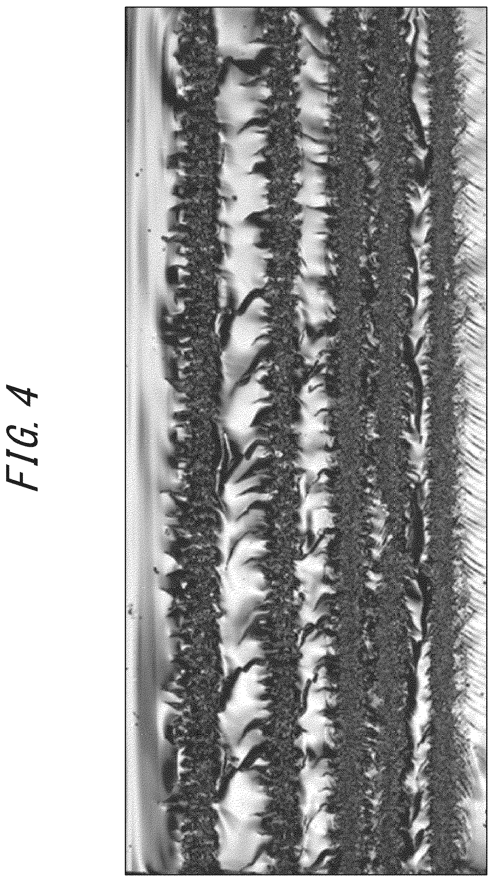

The arithmetical mean height (Sa) was calculated in accordance with ISO 25178-2:2012. Measurement of a side surface that had been cut by the laser scriber was performed using four samples. An average value of Sa for the total of 4 points was 3.5 μm. FIG. 4 presents an image taken by the profile analysis laser microscope with respect to a side surface of the sapphire substrate after separation.

(Example 2)

In Example 2, a light-emitting element was produced under the same conditions as in Example 1 with the exception that the thickness of the p-type blocking layer was set as 54 nm and the thickness of the p-type cladding layer was set as 29 nm. The total film thickness of the p-type blocking layer and the p-type cladding layer combined was 83 nm. The total thickness (L) of the p-side semiconductor layer, inclusive of the i-type guide layer and the p-type contact layer, was 88 nm.

(Example 3)

In Example 3, a light-emitting element was produced under the same conditions as in Example 1 with the exception that the thickness of the p-type blocking layer was set as 38 nm and the thickness of the p-type cladding layer was set as 41 nm. The total film thickness of the p-type blocking layer and the p-type cladding layer combined was 79 nm. The total thickness (L) of the p-side semiconductor layer, inclusive of the i-type guide layer and the p-type contact layer, was 84 nm.

(Comparative Example 1)

In Comparative Example 1, a light-emitting element was produced under the same conditions as in Example 1 with the exception that the thickness of the p-type blocking layer was set as 11 nm and the thickness of the p-type cladding layer was set as 53 nm. The total film thickness of the p-type blocking layer and the p-type cladding layer combined was 64 nm. The total thickness (L) of the p-side semiconductor layer, inclusive of the i-type guide layer and the p-type contact layer, was 69 nm.

(Comparative Example 2)

In Comparative Example 2, a light-emitting element was produced under the same conditions as in Example 1 with the exception that the thickness of the p-type blocking layer was set as 70 nm and the thickness of the p-type cladding layer was set as 29 nm. The total film thickness of the p-type blocking layer and the p-type cladding layer combined was 99 nm. The total thickness (L) of the p-side semiconductor layer, inclusive of the i-type guide layer and the p-type contact layer, was 104 nm.

(Comparative Example 3)

In Comparative Example 3, a light-emitting element was produced under the same conditions as in Example 1 with the exception that the thickness of the p-type blocking layer was set as 22 nm and the thickness of the p-type cladding layer was set as 41 nm. The total film thickness of the p-type blocking layer and the p-type cladding layer combined was 63 nm. The total thickness (L) of the p-side semiconductor layer, inclusive of the i-type guide layer and the p-type contact layer, was 68 nm.

(Evaluation of light emission output)

The light-emitting element of each example or comparative example was mounted on a submount made of AlN (size: 2 mm × 2 mm; thickness: 0.2 mm) by a flip chip method using spherical Au bumps. In a state with a heat sink made of Al connected to the AlN submount, a constant current power supply was used to pass a 350 mA current, during which, the forward voltage (Vf) was measured and the total luminous flux light emission output (Po) was also measured with the light-emitting element inserted into an integrating sphere such that the sapphire substrate side having a light extraction surface was facing toward the center of the integrating sphere.

For the light emission output (Po), five light-emitting elements were sampled from a central part of a wafer in each example, comparative example, or conventional example and were measured to perform sampling measurement, and an average value of the measurements was calculated. This average value for light emission output at 350 mA is shown in Table 3.

(Peak angle)

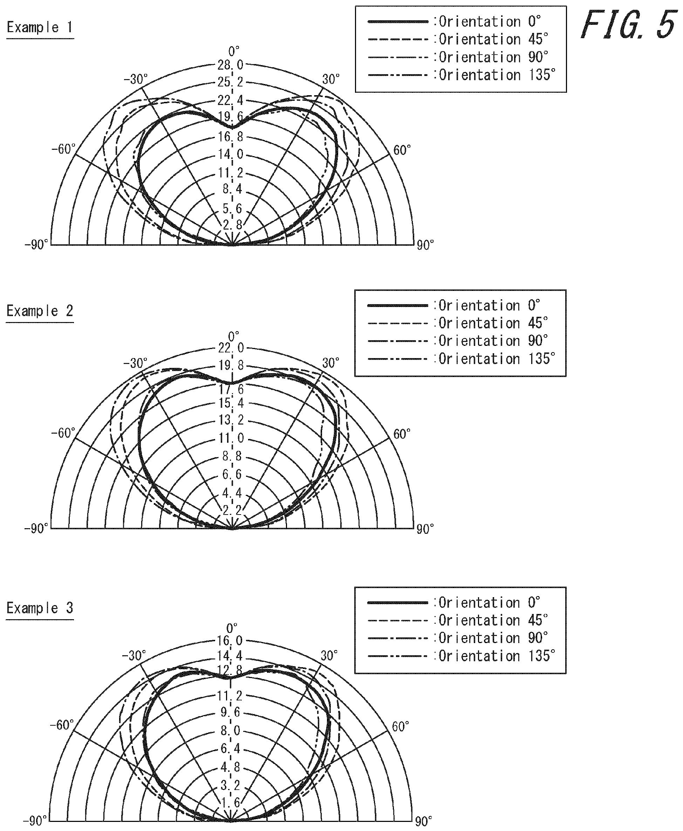

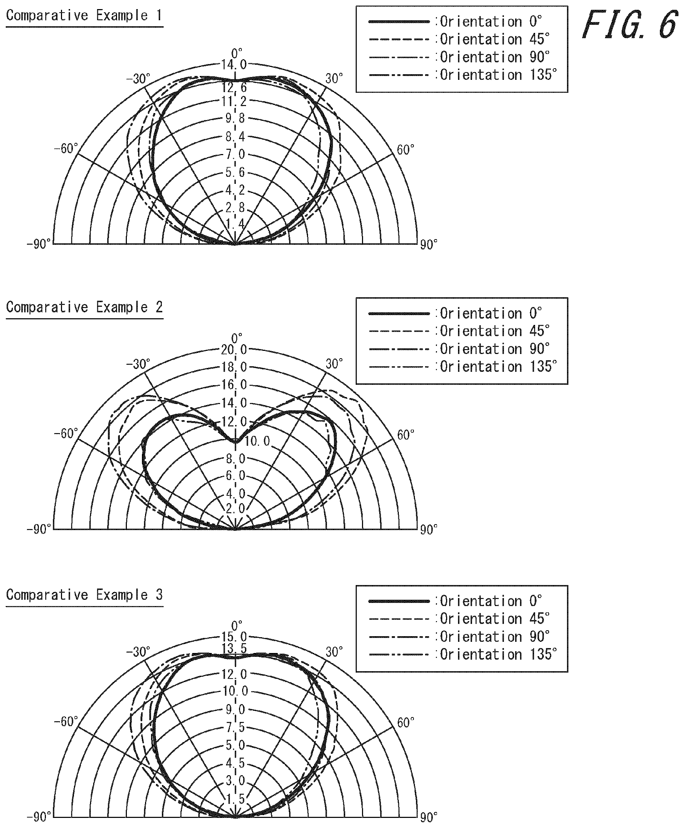

Details of the far field measurement technique are as previously described with reference to FIG. 2. Values for peak angles and average peak angles in light distribution patterns obtained by far field measurement are shown in Table 3. Moreover, light distribution patterns obtained by far field measurement for light-emitting elements obtained in the examples and comparative examples are presented in FIG. 5 and FIG. 6. The peak angles in a 1st measurement are taken to be peak angles 1. The peak angles 1 include a positive side peak angle in a range from 0° to 90° and a negative side peak angle in a range from 0° to -90°. In the same manner, peak angles 2 to peak angles 4 from the 2nd to 4th measurements are shown in Table 3. Note that the reason the peak angles differ in measurement of each of the four light distribution patterns is that the electrode shape of the light-emitting element is asymmetric with respect to the four rotations that were previously described.

[Table 3]

| | p-Type electron blocking layer thickness (nm) | p-Type cladding layer thickness (nm) | p-Type electron blocking layer + p-type cladding layer total thickness (nm) | p-Side semiconductor layer total thickness L (nm) | Peak angles 1 (orientation 0°) | | Peak angles 2 (orientation 45°) | | Peak angles 3 (orientation 90°) | | Peak angles 4 (orientation 135°) | | Average peak angle | Light emission output Po with 350 mA current (mW) |
|---|---|---|---|---|---|---|---|---|---|---|---|---|---|---|
| | | | | | Positive side | Negative side | Positive side | Negative side | Positive side | Negative side | Positive side | Negative side | | |
| Example 1 | 22 | 64 | 86 | 91 | 34° | 30° | 37° | 37° | 26° | 34° | 37° | 40° | 34° | 140 |
| Example 2 | 54 | 29 | 83 | 88 | 27° | 20° | 33° | 29° | 27° | 29° | 27° | 33° | 28° | 105 |
| Example 3 | 38 | 41 | 79 | 84 | 25° | 19° | 31° | 27° | 24° | 21° | 27° | 31° | 26° | 113 |
| Comparative Example 1 | 11 | 53 | 64 | 69 | 14° | 13° | 19° | 16° | 12° | 11° | 16° | 19° | 15° | 65 |
| Comparative Example 2 | 70 | 29 | 99 | 104 | 41° | 35° | 44° | 39° | 40° | 35° | 36° | 41° | 39° | 90 |
| Comparative Example 3 | 22 | 41 | 63 | 68 | 16° | 12° | 18° | 18° | 12° | 15° | 17° | 19° | 16° | 65 |

When the central emission wavelength $\lambda$ was measured by a spectrometer for the light-emitting elements according to the examples and comparative examples, the central emission wavelength of each light-emitting element was within a range of 340 nm $\pm$ 5 nm.

Moreover, each of the light-emitting elements according to the examples has a high average value for light emission output compared to the light-emitting elements according to the comparative examples. In other words, it was confirmed that in the case of a light-emitting element in which the total thickness (L) of a p-side semiconductor layer between a quantum well-type light-emitting layer and a reflective electrode satisfies $2L/\cos\theta = \lambda(2k + 1)/2n$ with respect to a central emission wavelength $\lambda$ (nm) of the quantum well-type light-emitting layer, a refractive index n of the p-side semiconductor layer, a natural number k, and an emission angle $\theta$ of light traveling toward inside of the p-side semiconductor layer from the quantum well-type light-emitting layer, and is within a range where the emission angle $\theta$ is an angle at which light would not be extracted from a transparent substrate into air in a case in which a main surface and a side surface of the transparent substrate are flat surfaces, such a light-emitting element has high light emission output compared to a light-emitting element for which this is not the case. Moreover, the average peak angle in light distribution patterns according to far field measurement for the light-emitting elements according to the examples was not less than 24° and not more than 37°, which roughly coincides with a range in which the emission angle $\theta$ is an angle at which light would not be extracted from a transparent substrate into air in a case in which a main surface and a side surface of the transparent substrate are flat surfaces. In this manner, according to the present disclosure, it is possible to provide an ultraviolet light-emitting element with which high light emission output is obtained.

An ultraviolet light-emitting element with which high light emission output is obtained and a method of producing the same can be provided as set forth above.

INDUSTRIAL APPLICABILITY

The present disclosure is applicable for an ultraviolet light-emitting element and a method of producing the same.

REFERENCE SIGNS LIST

| 1 | transparent substrate |
| 10 | p-side semiconductor layer |
| 11 | AlN layer |
| 100 | ultraviolet light-emitting element |
| 2 | buffer layer |
| 21 | first buffer layer |
| 22 | second buffer layer |
| 3 | n-type semiconductor layer |
| 31 | n-type guide layer |
| 4 | quantum well-type light-emitting layer |
| 41 | well layer |
| 42 | barrier layer |
| 5 | i-type guide layer |
| 6 | p-type electron blocking layer |
| 7 | p-type cladding layer |
| 8 | p-type contact layer |
| 91 | reflective electrode |
| 92 | n-side electrode |
| 200 | light-receiving element |

**Claims**

1. An ultraviolet light-emitting element comprising:

   a transparent substrate having a main surface that constitutes a light extraction surface;
   an AlN layer on the transparent substrate;
   an n-type semiconductor layer on the AlN layer;
   a quantum well-type light-emitting layer on the n-type semiconductor layer;
   a p-side semiconductor layer directly on the quantum well-type light-emitting layer; and

a reflective electrode directly on the p-side semiconductor layer, wherein
a side surface of the transparent substrate is a rough surface, and
thickness L (nm) of the p-side semiconductor layer satisfies formula (1), shown below:

$$2L/\cos\theta = \lambda(2k + 1)/2n \cdots (1)$$

with respect to a central emission wavelength $\lambda$, in units of nanometers, of the quantum well-type light emitting layer, a refractive index n of the p-side semiconductor layer, a natural number k, and an emission angle $\theta$ of light traveling toward inside of the p-side semiconductor layer from the quantum well-type light-emitting layer, and is within a range where the emission angle $\theta$ is an angle at which light extraction from the transparent substrate into air would not occur in a case in which the main surface and the side surface of the transparent substrate are flat surfaces.

2. The ultraviolet light-emitting element according to claim 1, wherein

the natural number k has a value of 1,
the emission angle $\theta$ is not less than 23.6° and not more than 36.8°, and
an average peak angle of a light distribution pattern according to far field measurement is not less than 24° and not more than 37°.

3. The ultraviolet light-emitting element according to claim 1 or 2, wherein
the p-side semiconductor layer includes:

a p-type electron blocking layer on the quantum well-type light-emitting layer;
a p-type cladding layer on the p-type electron blocking layer; and
a p-type contact layer on the p-type cladding layer, and
each layer among the n-type semiconductor layer, the p-type electron blocking layer, and the p-type cladding layer has a uniform composition in a horizontal direction.

4. The ultraviolet light-emitting element according to claim 1 or 2, wherein a value determined by dividing thickness of the p-type cladding layer by thickness of the p-type electron blocking layer is 0.4 or more.

5. A method of producing an ultraviolet light-emitting element comprising:

a step of forming an AlN layer on a surface at an opposite side of a transparent substrate relative to a main surface that constitutes a light extraction surface;
an n-type semiconductor layer formation step of forming an n-type semiconductor layer on the AlN layer;
a quantum well-type light-emitting layer formation step of forming a quantum well-type light-emitting layer on the n-type semiconductor layer;
a p-side semiconductor layer formation step of forming a p-side semiconductor layer directly on the quantum well-type light-emitting layer;
a reflective electrode formation step of forming a reflective electrode directly on the p-side semiconductor layer; and
a segmentation step of segmenting the transparent substrate, wherein
a side surface of the transparent substrate is made a rough surface in the segmentation step, and
the p-side semiconductor layer is formed such that thickness L, in units of nanometers, of the p-side semiconductor layer satisfies formula (1), shown below:

$$2L/\cos\theta = \lambda(2k + 1)/2n \cdots (1)$$

with respect to a central emission wavelength $\lambda$, in units of nanometers, of the quantum well-type light emitting layer, a refractive index n of the p-side semiconductor layer, a natural number k, and an emission angle $\theta$ of light traveling toward inside of the p-side semiconductor layer from the light-emitting layer, and is within a range where the emission angle $\theta$ is an angle at which light extraction from the transparent substrate into air would not occur in a case in which the main surface and the side surface of the transparent substrate are flat surfaces.

6. The method of producing an ultraviolet light-emitting element according to claim 5, wherein the p-side semiconductor layer formation step includes:

a p-type electron blocking layer formation step of forming a p-type electron blocking layer on the quantum well-type light-emitting layer;
a p-type cladding layer formation step of forming a p-type cladding layer on the p-type electron blocking layer; and
a p-type contact layer formation step of forming a p-type contact layer on the p-type cladding layer.

# FIG. 1

# FIG. 2

Light distribution angle 0°

200

Light distribution angle 40°

200

100mm

100mm

100

*FIG. 3*

EP 4 611 050 A1

*FIG. 4*

**Example 1**

FIG. 5

Legend:
- ——— :Orientation 0°
- - - - - :Orientation 45°
- —·—·— :Orientation 90°
- —··—··— :Orientation 135°

**Example 2**

Legend:
- ——— :Orientation 0°
- - - - - :Orientation 45°
- —·—·— :Orientation 90°
- —··—··— :Orientation 135°

**Example 3**

Legend:
- ——— :Orientation 0°
- - - - - :Orientation 45°
- —·—·— :Orientation 90°
- —··—··— :Orientation 135°

Comparative Example 1

FIG. 6

| | :Orientation 0° |
| --- | --- |
| | :Orientation 45° |
| | :Orientation 90° |
| | :Orientation 135° |

Comparative Example 2

| | :Orientation 0° |
| --- | --- |
| | :Orientation 45° |
| | :Orientation 90° |
| | :Orientation 135° |

Comparative Example 3

| | :Orientation 0° |
| --- | --- |
| | :Orientation 45° |
| | :Orientation 90° |
| | :Orientation 135° |

## INTERNATIONAL SEARCH REPORT

International application No.

**PCT/JP2023/038772**

### A. CLASSIFICATION OF SUBJECT MATTER

***H01L 33/20***(2010.01)i; ***H01L 33/10***(2010.01)i; ***H01L 33/32***(2010.01)i
FI: H01L33/20; H01L33/10; H01L33/32

According to International Patent Classification (IPC) or to both national classification and IPC

### B. FIELDS SEARCHED

Minimum documentation searched (classification system followed by classification symbols)

H01L33/00-33/64; H01S5/00-5/50

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | WO 2015/111134 A1 (SOKO KAGAKU CO., LTD.) 30 July 2015 (2015-07-30) paragraphs [0008]-[0030], [0036]-[0045], fig. 1-5, 9 | 1-6 |
| Y | US 2019/0013435 A1 (SILANNA UV TECHNOLOGIES PTE LTD.) 10 January 2019 (2019-01-10) paragraphs [0062]-[0077], fig. 2-4 | 1-6 |
| A | JP 2013-171992 A (FUJIFILM CORP.) 02 September 2013 (2013-09-02) paragraph [0002] | 1-6 |
| A | JP 2011-512037 A (LUMITEX, INC.) 14 April 2011 (2011-04-14) fig. 1 | 1-6 |
| A | JP 2004-247411 A (SHARP KABUSHIKI KAISHA) 02 September 2004 (2004-09-02) entire text, all drawings | 1-6 |
| A | JP 2021-517263 A (BOE TECHNOLOGY GROUP CO., LTD.) 15 July 2021 (2021-07-15) entire text, all drawings | 1-6 |

☑ Further documents are listed in the continuation of Box C.　　☑ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **13 December 2023** | **26 December 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2023/038772**

### C. DOCUMENTS CONSIDERED TO BE RELEVANT

| Category* | Citation of document, with indication, where appropriate, of the relevant passages | Relevant to claim No. |
|---|---|---|
| A | JP 2013-21250 A (KABUSHIKI KAISHA TOSHIBA) 31 January 2013 (2013-01-31) entire text, all drawings | 1-6 |

Form PCT/ISA/210 (second sheet) (January 2015)

## INTERNATIONAL SEARCH REPORT
### Information on patent family members

International application No.

**PCT/JP2023/038772**

| Patent document cited in search report | | | Publication date (day/month/year) | Patent family member(s) | | | Publication date (day/month/year) |
|---|---|---|---|---|---|---|---|
| WO | 2015/111134 | A1 | 30 July 2015 | US 2017/0077351 A1 paragraphs [0011]-[0033], [0055]-[0064], fig. 1-5, 9 | | | |
| US | 2019/0013435 | A1 | 10 January 2019 | WO 2017/145026 A1 TW 201740578 A | | | |
| JP | 2013-171992 | A | 02 September 2013 | US 2014/0361330 A1 paragraph [0005] WO 2013/125214 A1 EP 2819182 A1 | | | |
| JP | 2011-512037 | A | 14 April 2011 | US 2009/0289263 A1 fig. 1 WO 2009/100358 A1 CN 101939849 A KR 10-2010-0122485 A | | | |
| JP | 2004-247411 | A | 02 September 2004 | (Family: none) | | | |
| JP | 2021-517263 | A | 15 July 2021 | US 2020/0235543 A1 entire text, all drawings WO 2019/196563 A1 EP 3780301 A1 CN 110346859 A | | | |
| JP | 2013-21250 | A | 31 January 2013 | US 2013/0015481 A1 entire text, all drawings | | | |

Form PCT/ISA/210 (patent family annex) (January 2015)

**EP 4 611 050 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6814902 B
- WO 2017013729 A1
- JP 2015119108 A